# EUROPEAN PATENT SPECIFICATION

(11) **EP 1 449 234 B1**
(45) Date of publication and mention of the grant of the patent: **03.10.2007**
(21) Application number: 02777488.4
(22) Date of filing: 07.11.2002
(51) Int. Cl.: H01J 37/34

(54) **MAGNETRON SPUTTERING DEVICE**
MAGNETRON-SPUTTERVORRICHTUNG
DISPOSITIF DE PULVERISATION MAGNETRON

(30) Priority: 07.11.2001 GB 0126721
(43) Date of publication of application: 25.08.2004
(73) Proprietor: Monaghan, Dermot Patrick, Near Chorley, Lancashire PR6 8EY (GB); Bellido-Gonzalez, Victor, Liverpool L14 5PF (GB)
(72) Inventor: Monaghan, Dermot Patrick, Near Chorley, Lancashire PR6 8EY (GB); Bellido-Gonzalez, Victor, Liverpool L14 5PF (GB)
(74) Representative: W.P. Thompson & Co.
(86) International application number: PCT/GB2002/005046
(87) International publication number: WO 2003/041113

(56) References cited:
- DE-A- 4 000 941
- US-A- 4 405 436
- US-A- 4 414 087
- US-A- 4 572 776

## Description

The present invention relates to magnetron sputtering, more particularly to targets for magnetron sputtering, to a device including such a target and to a method of magnetron sputtering. Particularly, in certain embodiments the invention relates to magnetron sputter sources which are able to sputter off from ferromagnetic targets using larger thickness than conventional devices.

Magnetron sputtering of ferromagnetic materials such as metallic cobalt, nickel and iron is limited due to the high magnetic permeability of these metals. In the case of iron, for instance, a maximum of 1.5 mm target thickness can be sputtered using conventional methods. A target having a thickness of greater than 1.5 mm gives rise to a magnetic field of insufficient strength to produce the required plasma for sputtering.

A further drawback of conventional sputtering methods is that about 90% of the target material is trapped by the magnetic field and cannot be etched. These problems result in a process which is costly and inefficient in terms of target utilisation and wastage of time. Since only thin targets can be used, they must be replaced frequently, resulting in the inconvenience of stopping the process at regular intervals and then regenerating a vacuum after replacement. This process is neither cost effective nor time efficient.

Furthermore, existing methods cannot easily control the escape of ions from the target area towards the sample which is being coated, therefore film properties may vary from run to run. This poses limitations on the technology for which the film can be used, particularly for example for magnetic recording media.

US-A-4 414 087 discloses a target arrangement that has a casing dividing the sputtering device into atmospheric and low pressure sputtering zones.

It is an object of the present invention to provide a device and method for sputtering which addresses one or more of the above mentioned problems. Embodiments of the present invention may be based on magnetron sputtering sources where the ferromagnetic target to be sputtered is composed of at least two parts. Generally a gap between the several ferromagnetic parts can be present. By selecting the relative position and polarity of several magnetic means in relation to the ferromagnetic target parts it is possible to close magnetic field lines above the main ferromagnetic target material. Generally at least one of the ferromagnetic target parts can be above the surface level of the other part so a vault is created in which the electric and magnetic field confinement are enhanced. The magnetic field in the vault would have in general two main areas, one of high magnetic field strength and another one of a lower very homogeneous magnetic field strength. The magnetic and electric field design allows the sputtering at very low pressures. The sputtering of ferromagnetic material is stable during sputtering and low defects are created on the sputtered film.

According to the invention in a first aspect there is provided a target arrangement for use within a vacuum sputtering zone of a vacuum sputtering device comprising said vacuum sputtering zone and an atmospheric zone containing one or more magnets, the target arrangement comprising a casing that separates a low pressure vacuum sputtering zone from atmospheric conditions a primary target comprising material to be sputtered located on the low pressure side of the casing characterised in that the target further comprises an auxiliary target of ferromagnetic material, located in the low pressure side of the casing the targets being located relative to one another such that upon application of a magnetic field across the surface of the target, the magnetic field over the primary target is confined into an area of high homogeneous magnetic field strength substantially parallel to the surface of the primary target, to achieve uniform erosion across said area of target during sputtering.

The area of high homogeneous magnetic field need not prevail across the enire surface of the primary target, but will generally cover a partial area of the surface of the primary target.

Preferably, the primary target and auxiliary target are spaced apart by a gap, to enahnce the confinement of magnetic/electric field and sputtering operation.

Preferably, the auxiliary target has a surface which is raised beyond a surface of the primary target This creates a vault in which the confinement of magnetic field is enhanced. Preferably, the raised surface of the auxiliary target extends beyond the surface of the primary target by a height which is less than or equal to the width of the primary target. However, the auxiliary target may alternatively be arranged to have an exposed surface which is level with that of the primary target, for example when the primary target is of a non-magnetic material. In cases where there is more than one auxiliary target, each may be raised to a different height relative to the primary target.

Preferably, in each of the above mentioned aspects of the invention, there are a plurality of auxiliary targets. There may also be more than one primary target. In such case, preferably the auxiliary targets are located adjacent and between each of the primary targets.

Preferably the primary and auxiliary targets are of the same material. This avoids the risk of contamination resulting from any erosion of the auxiliary target during the sputtering process. However, it is also possible for the primary and auxiliary targets to be of different materials. Unlike the auxiliary target, the primary target need not be of magnetic material.

The targets may be planar or non-planar. Additionally, they may be circular, rectangular or any other geometry when viewed as a plan. The primary target may be profiled, e.g. to have a slotted surface, in order to decrease the operative pressure at which sputtering can take place.

The preferred dimensions of the targets and their relative positions will depend upon the materials used and the sputtering conditions. The gap between the primary target and auxiliary target is preferably not more than 10 mm wide, more preferably not more than 5 mm wide. Yet more preferably, the gap is between 1 and 2 mm in width.

The gap need not divide the primary and auxiliary targets entirely, but may extend only partially between the targets, along their surface. The preferred depth of the gap varies depending upon materials and conditions. Preferably, the gap has a depth of at least 30% when compared with the thickness of the primary target. More preferably, the gap extends down to at least 70% of the thickness of the primary target. Most preferably, the depth of the gap is between 90% and 100% of the thickness of the primary target. Where the gap does not extend to the full thickness of the primary target, the primary and auxiliary targets can be integral and thus of the same material. Alternatively, the primary and auxiliary targets are discrete targets which can be removed and replaced independently. This is particularly advantageous since the primary target will be eroded faster than the auxiliary target. Generally, over a period of time in which the primary target is replaced 10 times, the auxiliary target will only need to be replaced once.

Preferably the primary and auxiliary targets are mounted on a backing plate. The backing plate may be planar, so that the targets are mounted at the same level, or may for example be stepped so that the primary and auxiliary targets are mounted at different base levels. In some embodiments having a plurality of auxiliary targets, it is preferable that these be mounted on the backing plate from different base levels. There may be more than one backing plate, and the primary and auxiliary targets need not be mounted on the same backing plate.

According to a second aspect of the invention there is provided a device for magnetron sputtering comprising the target arrangement of the first aspect of the invention, and further comprising:
magnetic means for creating a magnetic field in a region above the targets,
the magnetic field over the primary target being confined into an area of high homogeneous magnetic field strength substantially parallel to the surface of the primary target.

Preferably, the magnetic means are provided directly behind, or in the proximity of the auxiliary target to produce the required magnetic field strength distribution.

According to a third aspect of the invention there is provided the use of the device of the first aspect for magnetron sputtering.

By confining a high magnetic field strength to a specific desired area, the present invention enables the use of thicker targets when compared with conventional methods. Generally, the invention allows the use of a target thickness of 5 - 10 times that of conventional sputtering. For example, a primary target having thickness of 5 - 6 mm may be used in the case of iron, while a nickel target of up to 10 mm thickness may be employed. As a result, the target need not be replaced as frequently, offering savings in time and expense.

Additionally, owing to the shape of the magnetic field generated, the present invention enables a much higher target utilisation, which can be greater than 50%, compared with conventional methods which generally only allow less than 10% of the target to be eroded before replacement. This further reduces wastage of materials, thus improving cost and time efficiency.

A further advantage of the present invention is that it allows sputtering at very low pressures, which enables the production of better quality coatings having a lower density of defects.

The invention will now be described in detail, by way of example only, with reference to the accompanying drawings in which:
Figure 1 is a cross section of an arrangement according to a first preferred embodiment of the invention.
Figure 2 is a cross section of an arrangement according to a second preferred embodiment of the invention.
Figure 3 is a cross section of an arrangement according to a third preferred embodiment of the invention.
Figure 4a is a cross section of an arrangement according to a fourth preferred embodiment of the invention.
Figure 4b is a detailed cross section of the embodiment of Fig. 4a.
Figure 4c is a plot of flux density against distance with reference to locations along the arrow line of Fig. 4b.
Figure 5 is a cross section of an arrangement according to a fifth preferred embodiment of the invention.
Figure 6 is a cross section of a comparative arrangement, shown for comparison with the embodiments of the present invention.
Figure 7 is a cross section of an arrangement according to a sixth preferred embodiment of the invention.
Figure 8a is a cross section of an arrangement according to a seventh preferred embodiment of the invention.
Figure 8b is an enlarged detail of the embodiment of Fig. 8a, showing the distribution of magnetic-field.
Figure 9a is a cross section of an arrangement according to an eighth preferred embodiment of the invention.
Figure 9b is an enlarged detail of the embodiment of Fig. 9a.
Figure 10 is a cross section of an arrangement according to a ninth preferred embodiment of the invention.

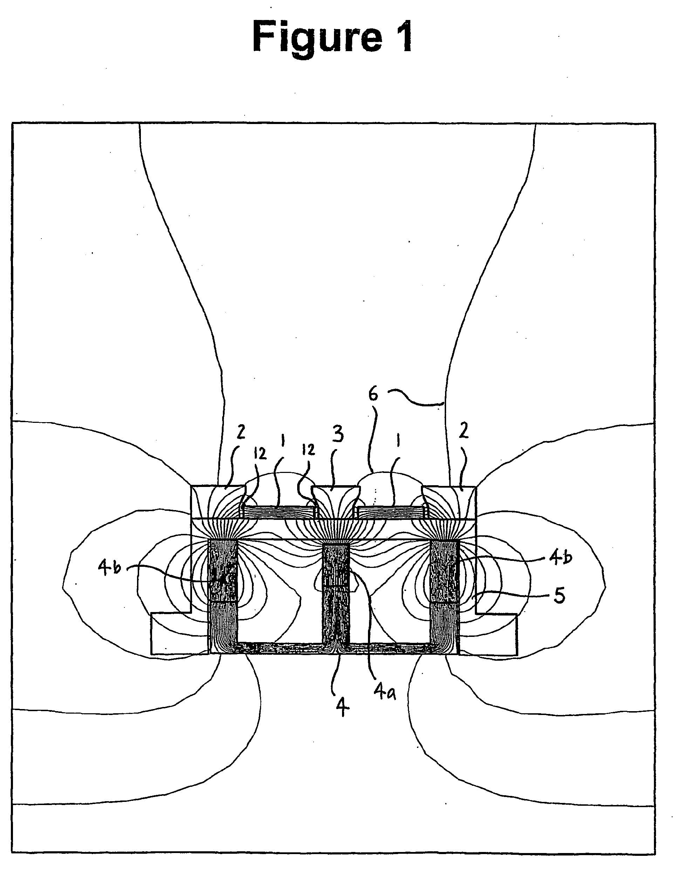

Referring to Fig. 1, this shows a magnetic array and a ferromagnetic target, the target having three parts. The primary target 1 provides the main material to be sputtered. Separating and surrounding the primary target 1 are two other target parts, an outer auxiliary target 2 and an inner auxiliary target 3. A gap 12 separates the primary target 1 from each of the auxiliary targets 2 and 3.

Below each of the auxiliary targets 2 and 3 are located magnetic means 4, comprising magnetic poles 4a and 4b. A casing 5 separates the low pressure zone, in which the targets are located, from atmospheric conditions. In the embodiment shown, the casing 5 includes an integral base plate onto which the targets 1, 2 and 3 are mounted.

The auxiliary targets 2, 3 are raised above the plane of the primary target 1. The relative position of magnetic poles 4a and 4b with respect to the three different target parts enables the magnetic field to be conducted across in field lines 6, to produce a closed field between the auxiliary targets 2 and 3. As a result, a stable, homogeneous, low magnetic field is produced above the surface of the central region of the primary target, causing this area to be eroded by plasma while the outer edge parts of the primary target experience negligible erosion. Similarly, the auxiliary targets 2 and 3 undergo only a small amount of erosion. The gradual erosion of the primary target occurs in a uniform manner so that some 50% of the target material may be used before replacement. In contrast, the auxiliary targets 2, 3, which are not substantially eroded, need not be replaced frequently, if at all. In summary, the electric field created when the target is biased during the sputtering process, together with the magnetic field structure, enables sputtering at very low pressures.

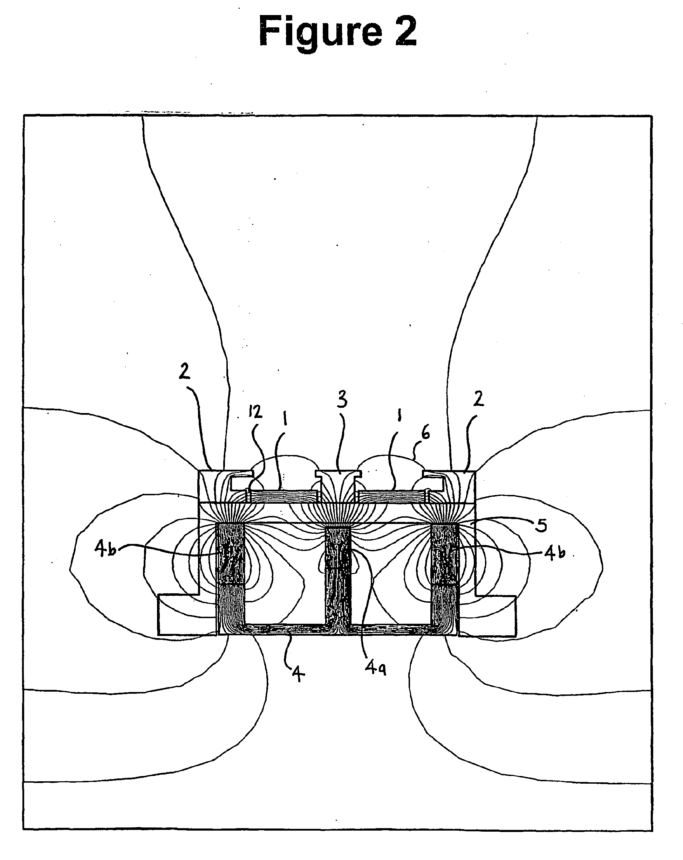

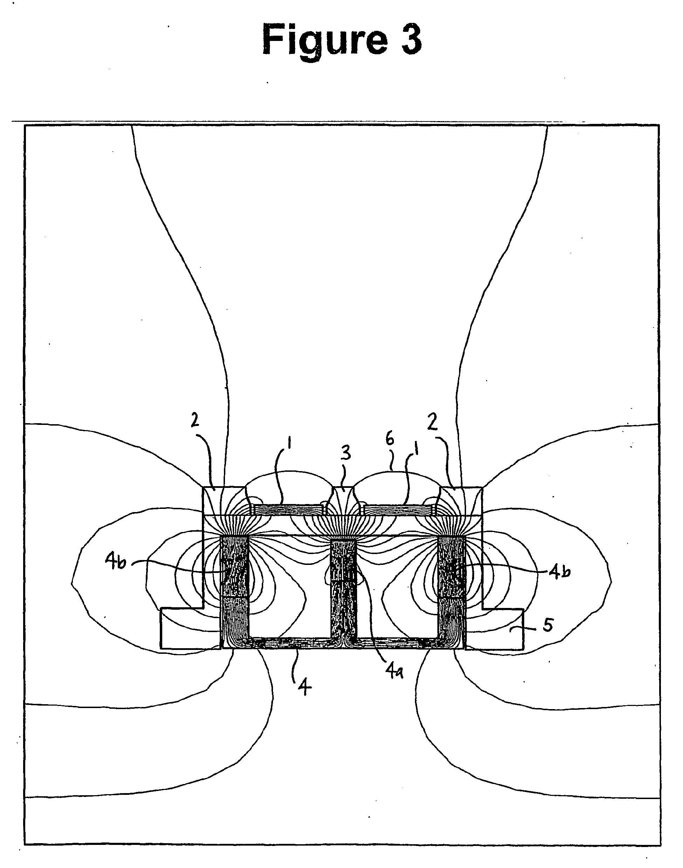

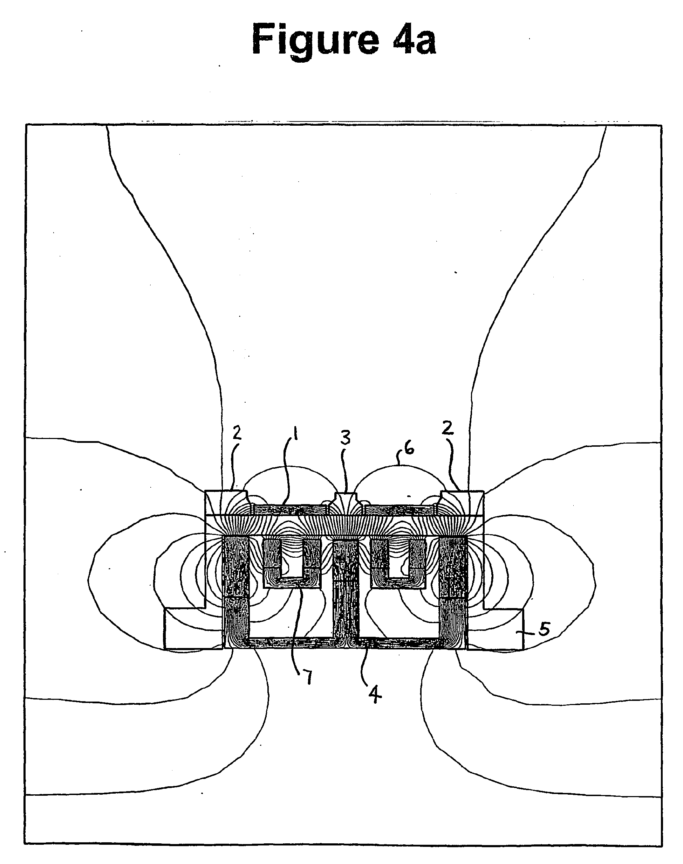

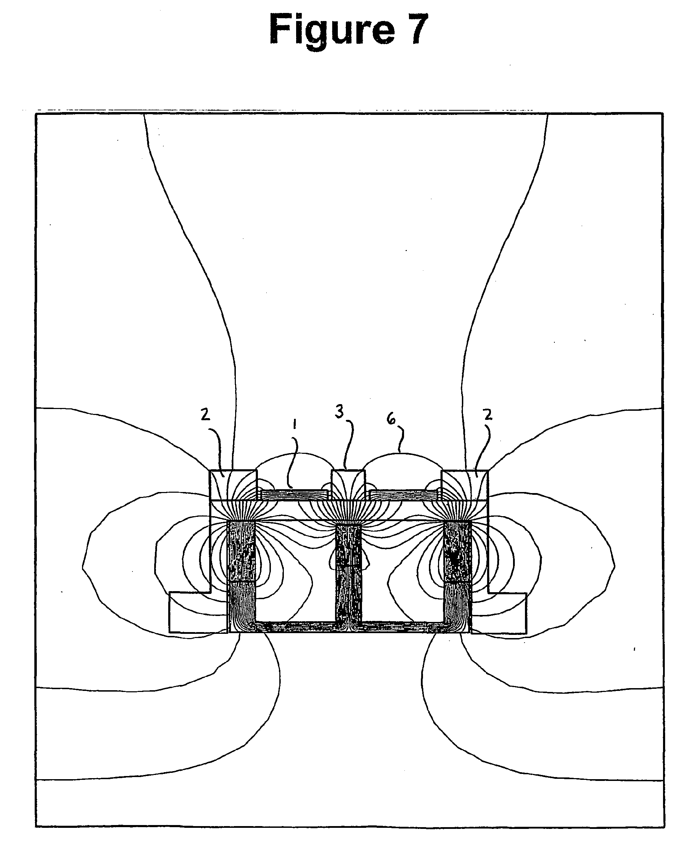

Figs. 2 and 3 show the same arrangement of targets and magnetic means, the profile of the auxiliary targets 2 and 3 having been modified to produce a different electric and magnetic field distribution. By modifying the profile of the auxiliary targets, the extent of their erosion by sputtering can be minimised. This is particularly desirable when the auxiliary targets are of different material from that of the primary targets, since erosion of the auxiliary targets would lead to contamination of the coating material. -With a square profile, such as in Fig. 7, or a protruding profile such as is shown in Fig. 1, the upper corner area of the auxiliary target tends gradually to become eroded, with some deposition of material occurring in the region below this area. This unwanted erosion can be reduced by profiling the upper corner of the auxiliary target along an incline as shown for example in Figs. 3 and 4a. Fig. 2 shows a further possible profile which may be employed, though the shape depicted would again result in some unwanted erosion. The design of the targets in Fig. 3 also allows easier replacement of the primary targets.

In the embodiment shown in Fig. 4a, additional magnetic means 7 are present to enhance saturation of magnetic field and to boost magnetic field strength, as shown by magnetic field lines 6. The saturation of the primary target 1 is thus enhanced, enhancing plasma confinement by magnetic field lines 6. This enables a yet thicker primary target to be used for sputtering.

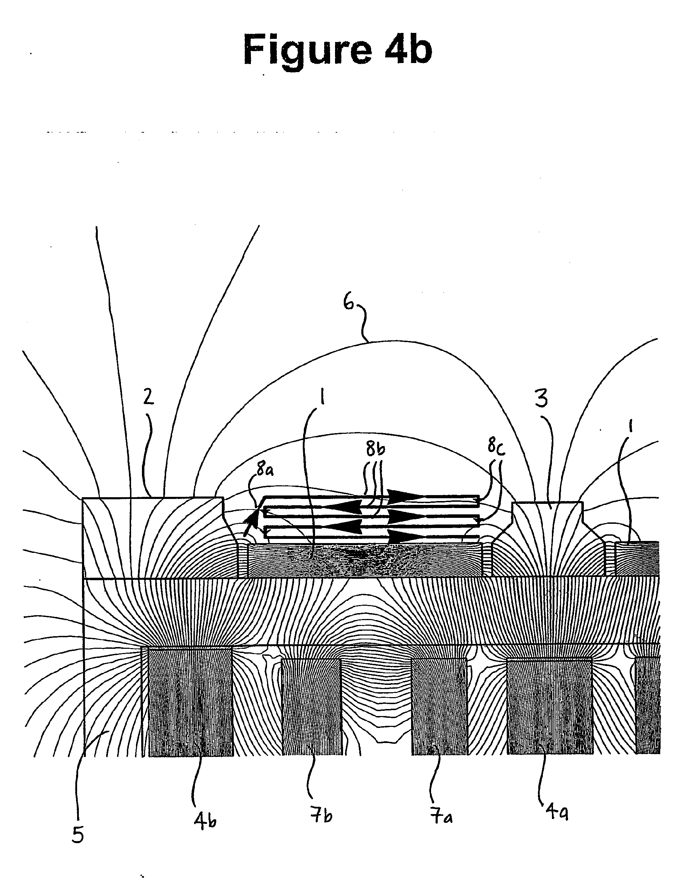

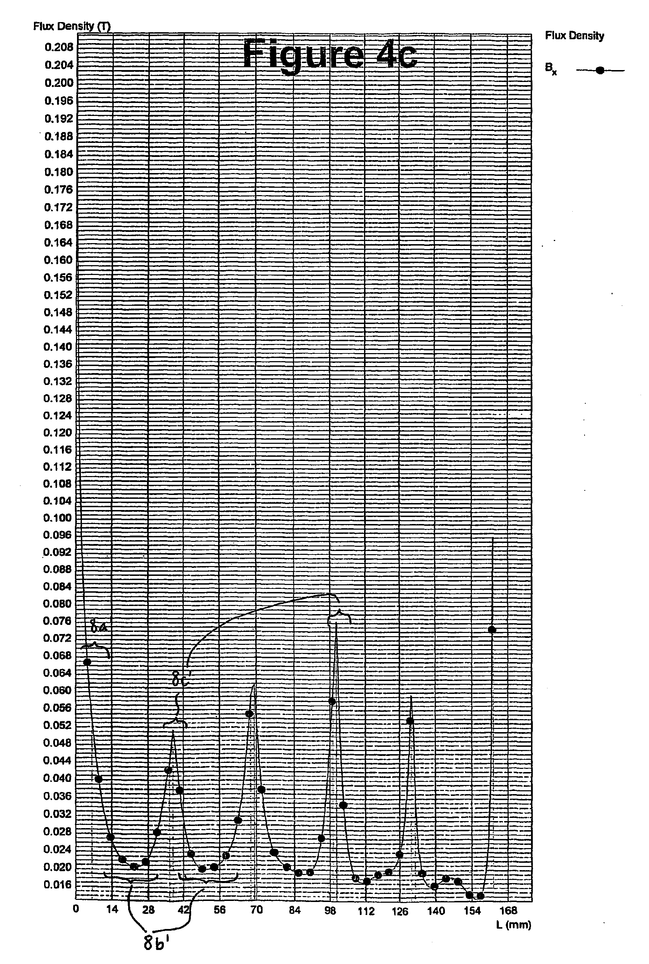

Referring to Fig. 4b, the magnetic field lines are shown in more detail. Magnetic field strength (Bx) was measured in the region above the primary target 1 along the arrow line 8a-8b-8c, and the results plotted in Fig. 4c. Referring to Fig. 4c, the points in the regions labelled 8a', 8b' and 8c' correspond respectively to the regions along sections 8a, 8b and 8c of Fig. 4b. As shown, the magnetic field is trapped in areas of high strength at 8a and 8c and areas of lower, homogeneous field strength at 8b.

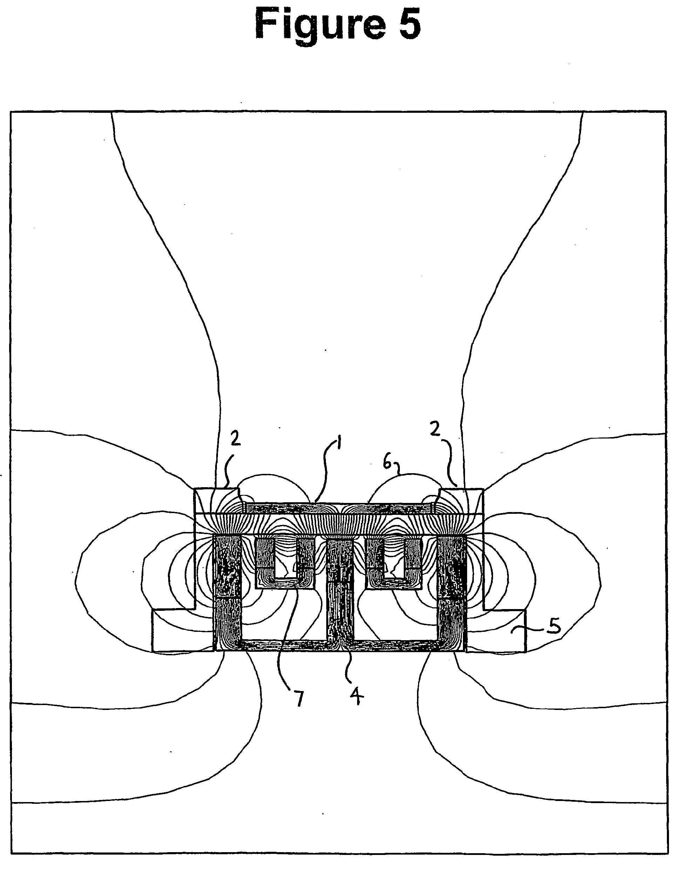

The embodiment of Fig. 5 resembles that of Fig. 4a except that the central auxiliary target 3 is not present, the target having only two parts. As shown by the magnetic field lines 6, the arrangement still produces a closed magnetic field in two regions across the primary target 1, though the magnetic confinement has been reduced when compared with Fig. 4a.

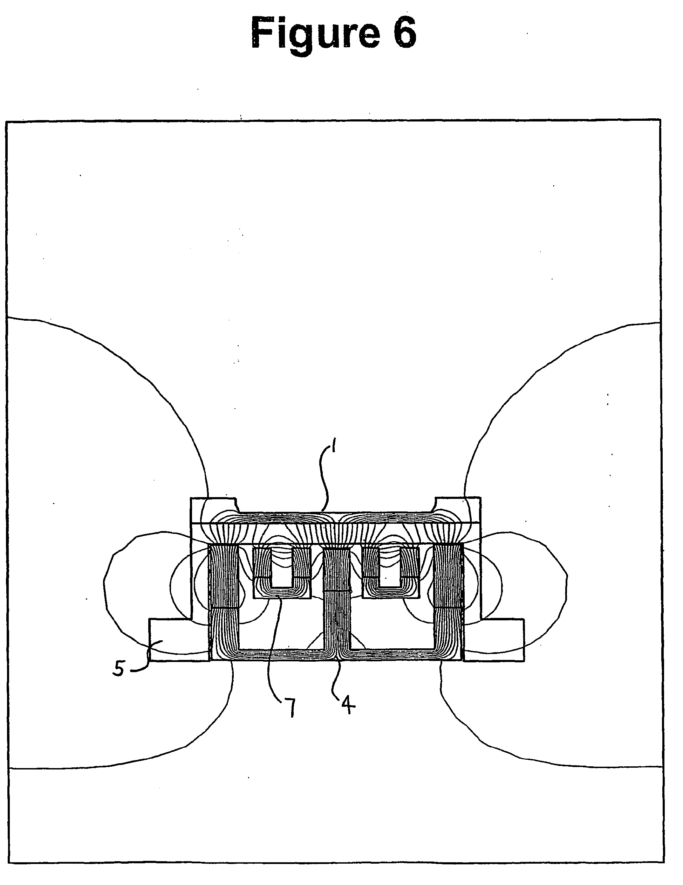

In Fig. 6 however, the gap between the primary and auxiliary targets has been closed so that a single target 1 is now present. The absence of a gap results in a much lower magnetic field strength in the region above the target, as shown by lines 6. Consequently the special magnetic confinement shown in the other figures has been lost, and the desired result of the present invention is not achieved.

In contrast, Fig. 7 shows a further possible variation within the scope of the invention. The profile of the primary target 1 has again been modified to alter the exact shape and strength of the magnetic field.

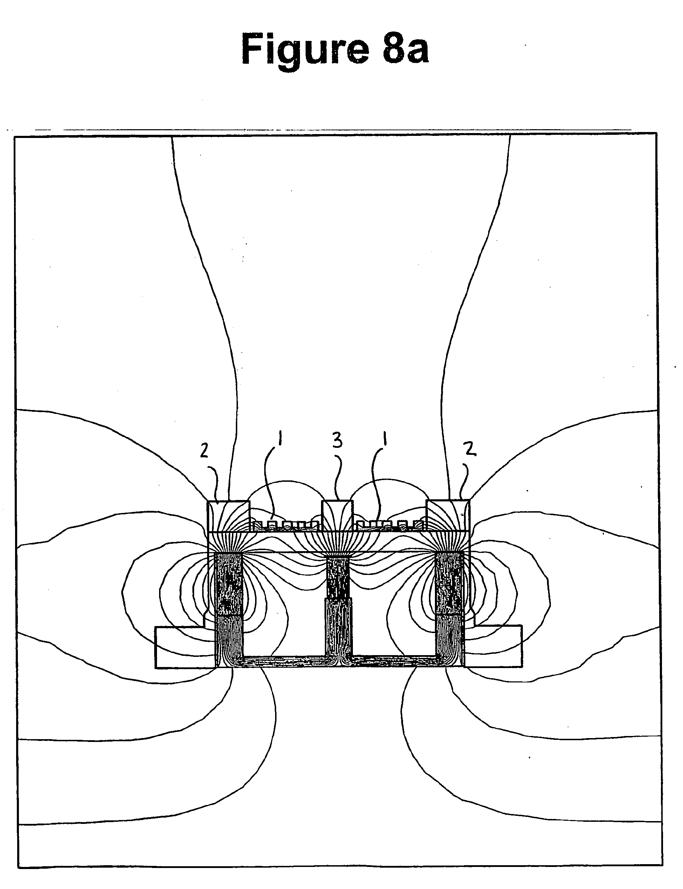

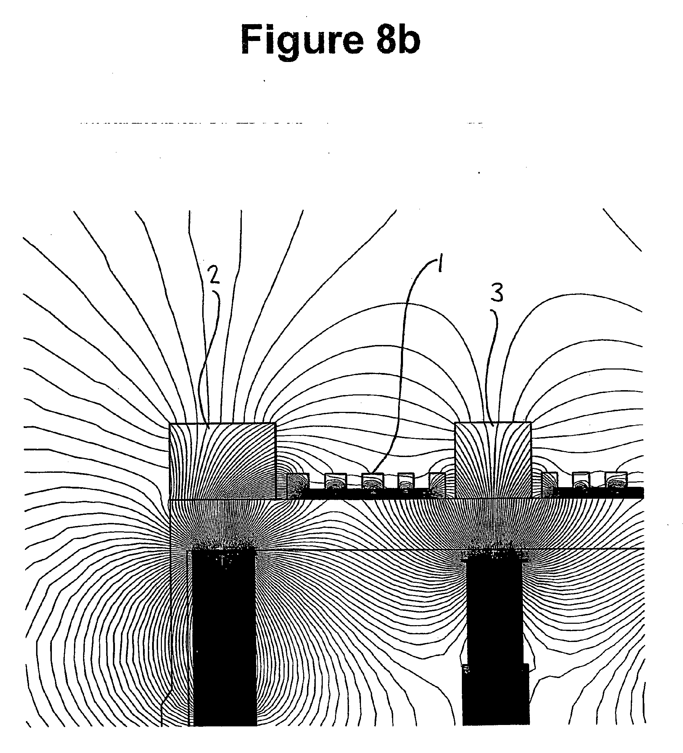

Figs. 8a and 8b illustrate a possible variation in the surface profile of the primary target. The surface has a slotted profile, which may further reduce the pressure at which sputtering can be performed.

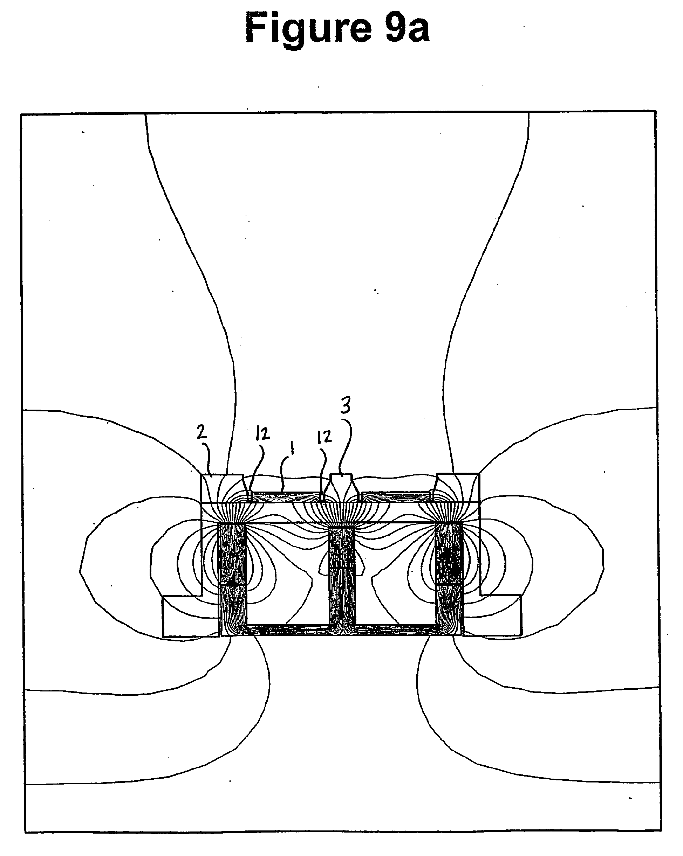

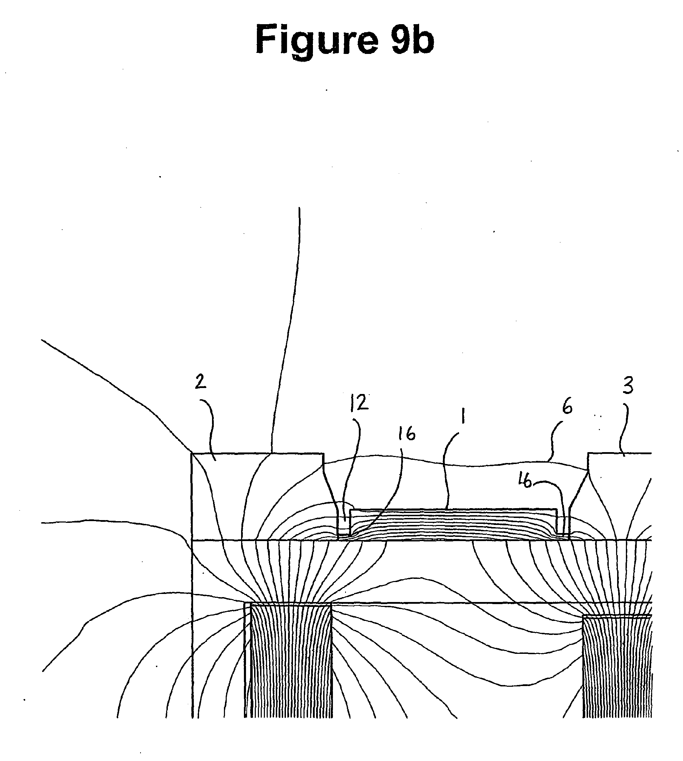

In Figs. 9a and 9b, the gaps 12 between the primary and auxiliary targets do not divide the targets entirely. Adjacent the point of contact with the base plate, the targets contact each other. The primary targets are provided with extending flanges 16 which contact the auxiliary target. This arrangement has the advantage that the targets can be easily and correctly located on the base plate during assembly. Also the primary target can be removed and replaced separately from the auxiliary targets when necessary.

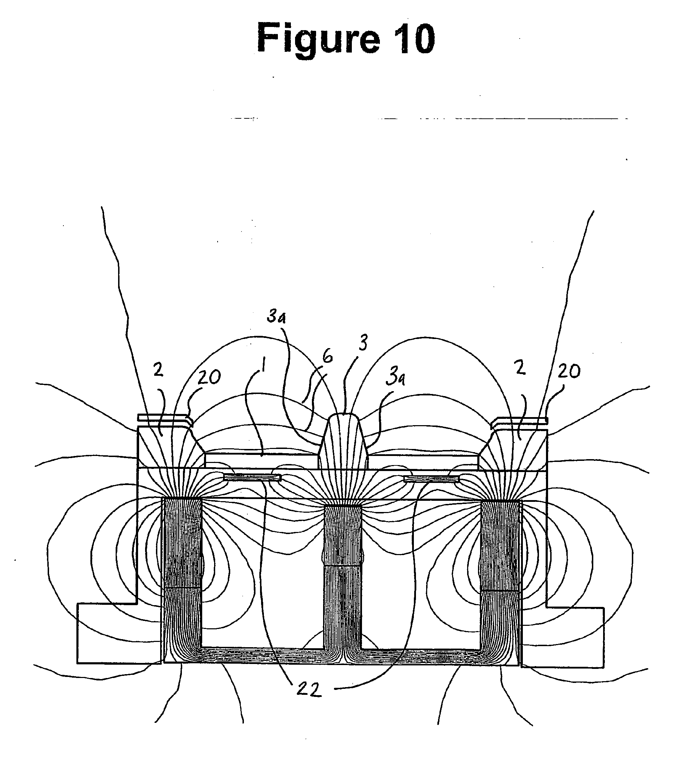

In Fig. 10, the primary target 1 is of a non-magnetic material. In this embodiment, a gap between the primary and auxiliary targets is not necessary, and the targets are shown to but against each other. An anode 20 is located over the outer auxiliary target 2. This blocks plasma from contacting the auxiliary target 2 and stops erosion of its surface, thus acting as a shield. This has the effect of concentrating the plasma over the primary target 1 instead, where it is desired for etching. The anode may be of any suitable material, for example titanium, aluminium or stainless steel. The anode can be grounded to earth, floating or can be biased to have higher potential than the cathode.

A small amount of redeposition of material occurs on the side surfaces 3a of the central auxiliary target 3, and this prevents unwanted erosion at the surfaces of the auxiliary target.

Also shown in Fig. 10 is an additional ferromagnet 22, which has the effect of shifting the magnetic field lines 6 to have a flatter profile, more generally parallel to the surface of the primary target 1. This alters the distribution of erosion across the surface of the primary target, producing a flatter, more even profile of erosion which enables a larger percentage yield of sputtered material and more efficient target utilisation.

The above description merely sets out various preferred embodiments of the invention, and it will be appreciated that further modifications can be applied without departing from the scope of the invention as claimed.

## Claims

1. A target arrangement for use within a vacuum sputtering zone of a vacuum sputtering device comprising said vacuum sputtering zone and an atmospheric zone containing one or more magnets (4), the target arrangement comprising
a casing (5) that separates a low pressure vacuum sputtering zone from atmospheric conditions
a primary target (1) comprising material to be sputtered located on the low pressure side of the casing **characterised in that** the target further comprises
an auxiliary target (2) of ferromagnetic material, located in the low pressure side of the casing, the targets (1, 2) being located relative to one another such that upon application of a magnetic field across the surface of the targets (1, 2), the magnetic field over the primary target (1) is confined into an area of high homogeneous magnetic field strength (6) substantially parallel to the surface of the primary target, (1) to achieve uniform erosion across said area of target (1) during sputtering.

2. A target arrangement according to claim 1 wherein the targets (1,2) are mounted on a backing plate.

3. A target arrangement according to claim 2, wherein the casing includes an integral base plate onto which the targets (1,2) are mounted.

4. A target arrangement according to claim 1,2, or 3 wherein the primary target (1) and auxiliary target (2) are spaced apart by a gap (12), to enhance the confinement of magnetic/electric field and sputtering operation.

5. A target arrangement according to any preceding claim wherein the auxiliary target (2) has a surface which is raised beyond a surface of the primary target (1).

6. A target arrangement according to any one of the preceding claims wherein the raised surface of the auxiliary target (2) extends beyond the surface of the primary target (1) by a height which is less than or equal to the width of the primary target (1).

7. A target arrangement according to any one of the preceding claims comprising a plurality of auxiliary targets (2,3).

8. A target arrangement according to any one of the preceding claims comprising a plurality of auxiliary targets (2,3) which are raised to different heights above the primary target (1).

9. A target arrangement according to any one of the preceding claims wherein the primary target (1) and auxiliary target (2) are of the same material.

10. A target arrangement according to any one of the claims 1 to 8 wherein the primary target (1) and auxiliary target (2) are of different materials.

11. A target arrangement according to claim 10 wherein the primary target (1) is of non-magnetic material.

12. A target arrangement according to any one of the preceding claims wherein the targets (1,2) are mounted at different base levels.

13. A target arrangement according to any one of the preceding claims wherein there is more than one backing plate and wherein the targets (1,2) are not all mounted on the same backing plate.

14. A target arrangement according to any one of the preceding claims wherein the primary target (1) can be replaced independently of the auxiliary target (2).

15. A target arrangement according to any one of the claims 4 to 13 wherein the gap (12) between the primary target (1) and auxiliary target (2) is not more than 10 mm in width.

16. A target arrangement according to any one of the preceding claims wherein the gap (12) between the primary target (1) and auxiliary target (2) is not more than 5 mm in width.

17. A target arrangement according to any one of the preceding claims wherein the gap (12) between the primary target (1) and auxiliary target (2) is between 1 and 2 mm in width.

18. A target arrangement according to any one of the preceding claims wherein the gap (17) between the primary target (1) and auxiliary target (2) has a depth of at least 30% of the thickness of the primary target (1).

19. A target arrangement according to any one of the preceding claims wherein the gap (12) between the primary target (1) and auxiliary target (2) has a depth of at least 70% of the thickness of the primary target (1).

20. A target arrangement according to any one of the preceding claims wherein the gap (12) between the primary target (1) and auxiliary target (2) has a depth of between 90% and 100% of the thickness of the primary target (1).

21. A target arrangement according to any one of the preceding claims wherein the primary target (1) is profiled, having a slotted surface.

22. A device for use in vacuum deposition process comprising a target arrangement according to any one of the preceding claims.

23. A device for magnetron sputtering comprising the target arrangement of any one of the preceding claims, and further comprising:
magnetic means (4) for creating a magnetic field in a region over the targets (1,2),
the magnetic field over the primary target (1) being confined into an area of high homogenous magnetic field strength (6) substantially parallel to the surface of the primary target (1).

24. A device according to claims 23, wherein the magnetic means (4) are located directly behind, or in the proximity of the auxiliary target (2).

25. Use of a device according to claim 23 or 24 for sputtering.

## Patentansprüche

1. Targetanordnung für die Verwendung in einer Vakuumzerstäubungszone einer Vakuumzerstäubungsvorrichtung, die die genannte Vakuumzerstäubungszone und eine atmosphärische Zone umfasst, die ein oder mehrere Magnete (4) beinhaltet, wobei die Targetanordnung Folgendes umfasst:
ein Gehäuse (5), das eine Niederdruck-Vakuumzerstäubungszone von atmosphärischen Bedingungen trennt,
ein Primärtarget (1), das aufzustäubendes Material aufweist, das sich auf der Niederdruckseite des Gehäuses befindet, **dadurch gekennzeichnet, dass** das Target ferner Folgendes umfasst:
ein Zusatztarget (2) aus ferromagnetischem Material, das sich auf der Niederdruckseite des Gehäuses befindet, wobei die Targets (1, 2) relativ zueinander so positioniert sind, dass nach dem Anlegen eines Magnetfelds an die Oberfläche der Targets (1, 2) das Magnetfeld über dem Primärtarget (1) auf einen Bereich mit einer hohen homogenen Magnetfeldstärke (6) im Wesentlichen parallel zur Oberfläche des Primärziels (1) begrenzt wird, um eine gleichförmige Erosion über den genannten Bereich von Target (1) beim Zerstäuben zu erzielen.

2. Targetanordnung nach Anspruch 1, bei der die Targets (1, 2) auf einer Trägerplatte montiert sind.

3. Targetanordnung nach Anspruch 2, bei der das Gehäuse eine integrierte Basisplatte beinhaltet, auf der die Targets (1, 2) montiert sind.

4. Targetanordnung nach Anspruch 1, 2 oder 3, bei der das Primärtarget (1) und das Zusatztarget (2) durch eine Lücke (12) voneinander beabstandet sind, um die Begrenzung von magnetischem/elektrischem Feld und den Zerstäubungsbetrieb zu verbessern.

5. Targetanordnung nach einem der vorherigen Ansprüche, bei der das Zusatztarget (2) eine Oberfläche hat, die über eine Oberfläche des Primärtargets (1) hinaus erhaben ist.

6. Targetanordnung nach einem der vorherigen Ansprüche, bei der die erhabene Oberfläche des Zusatztargets (2) über die Oberfläche des Primärtargets (1) um eine Höhe hinaus verläuft, die gleich oder kleiner ist als die Breite des Primärtargets (1).

7. Targetanordnung nach einem der vorherigen Ansprüche, die mehrere Zusatztargets (2, 3) umfasst.

8. Targetanordnung nach einem der vorherigen Ansprüche, die mehrere Zusatztargets (2, 3) umfasst, die bis auf unterschiedliche Höhen oberhalb des Primärtargets (1) erhaben sind.

9. Targetanordnung nach einem der vorherigen Ansprüche, bei der das Primärtarget (1) und das Zusatztarget (2) aus demselben Material bestehen.

10. Targetanordnung nach einem der Ansprüche 1 bis 8, bei der das Primärtarget (1) und das Zusatztarget (2) aus unterschiedlichen Materialien bestehen.

11. Targetanordnung nach Anspruch 10, bei der das Primärtarget (1) aus einem nichtmagnetischen Material besteht.

12. Targetanordnung nach einem der vorherigen Ansprüche, bei der die Targets (1, 2) auf unterschiedlichen Basisniveaus montiert sind.

13. Targetanordnung nach einem der vorherigen Ansprüche, bei der mehr als eine Trägerplatte vorhanden ist und bei der die Targets (1, 2) nicht alle auf derselben Trägerplatte montiert sind.

14. Targetanordnung nach einem der vorherigen Ansprüche, bei der das Primärtarget (1) unabhängig von dem Zusatztarget (2) ersetzt werden kann.

15. Targetanordnung nach einem der Ansprüche 4 bis 13, bei der die Lücke (12) zwischen dem Primärtarget (1) und dem Zusatztarget (2) eine Breite von nicht mehr als 10 mm hat.

16. Targetanordnung nach einem der vorherigen Ansprüche, bei der die Lücke (12) zwischen dem Primärtarget (1) und dem Zusatztarget (2) eine Breite von nicht mehr als 5 mm hat.

17. Targetanordnung nach einem der vorherigen Ansprüche, bei der die Lücke (12) zwischen dem Primärtarget (1) und dem Zusatztarget (2) eine Breite zwischen 1 und 2 mm hat.

18. Targetanordnung nach einem der vorherigen Ansprüche, bei der die Lücke (17) zwischen dem Primärtarget (1) und dem Zusatztarget (2) eine Tiefe von wenigstens 30% der Dicke des Primärtargets (1) hat.

19. Targetanordnung nach einem der vorherigen Ansprüche, bei der die Lücke (12) zwischen dem Primärtarget (1) und dem Zusatztarget (2) eine Tiefe von wenigstens 70% der Dicke des Primärtargets (1) hat.

20. Targetanordnung nach einem der vorherigen Ansprüche, bei der die Lücke (12) zwischen dem Primärtarget (1) und dem Zusatztarget (2) eine Tiefe zwischen 90% und 100% der Dicke des Primärtargets (1) hat.

21. Targetanordnung nach einem der vorherigen Ansprüche, bei der das Primärtarget (1) profiliert ist und eine geschlitzte Oberfläche hat.

22. Vorrichtung zur Verwendung in einem Vakuumaufdainpfungsprozess, die eine Targetanordnung nach einem der vorherigen Ansprüche umfasst.

23. Vorrichtung zum Magnetronzerstäuben, die die Targetanordnung nach einem der vorherigen Ansprüche hat und ferner Folgendes umfasst:
Magnetmittel (4) zum Erzeugen eines Magnetfeldes in einer Region über den Targets (1, 2),
wobei das Magnetfeld über dem Primärtarget (1) auf einen Bereich mit hoher homogener Magnetfeldstärke (6) im Wesentlichen parallel zur Oberfläche des Primärmagnets (1) begrenzt wird.

24. Vorrichtung nach Anspruch 23, wobei sich das Magnetmittel (4) unmittelbar hinter dem oder in der Nähe des Zusatztarget(s) (2) befindet.

25. Verwendung einer Vorrichtung nach Anspruch 23 oder 24 zum Zerstäuben.

## Revendications

1. Agencement de cibles destiné à être utilisé dans une zone de pulvérisation sous vide d'un dispositif de pulvérisation sous vide comprenant ladite zone de pulvérisation sous vide et une zone atmosphérique contenant un ou plusieurs aimants (4), l'agencement de cibles comprenant
un boîtier (5) qui sépare une zone de pulvérisation sous vide à basse pression des conditions atmosphériques
une cible principale (1) comprenant une matière à pulvériser située côté basse pression du boîtier **caractérisé en ce que** la cible comprend en outre
une cible auxiliaire (2) de matière ferromagnétique, située côté basse pression du boîtier, les cibles (1, 2) étant situées l'une par rapport à l'autre de telle sorte qu'à l'application d'un champ magnétique à travers la surface des cibles (1, 2), le champ magnétique sur la cible principale (1) soit confiné à une zone d'une grande force de champ magnétique homogène (6) sensiblement parallèle à la surface de la cible principale (1) afin de réaliser une érosion uniforme à travers ladite zone de la cible (1) durant la pulvérisation.

2. Agencement de cibles selon la revendication 1, dans lequel les cibles (1, 2) sont montés sur une plaque de support.

3. Agencement de cibles selon la revendication 2, dans lequel le boîtier comporte une plaque de base intégrée sur laquelle sont montées les cibles (1, 2).

4. Agencement de cibles selon la revendication 1, 2 ou 3, dans lequel la cible principale (1) et la cible auxiliaire (2) sont espacées par un espace (12), afin de rehausser le confinement du champ magnétique/électrique et l'opération de pulvérisation.

5. Agencement de cibles selon l'une quelconque des revendications précédentes, dans lequel la cible auxiliaire (2) a une surface qui est surélevée au-delà d'une surface de la cible principale (1).

6. Agencement de cibles selon l'une quelconque des revendications précédentes, dans lequel la surface surélevée de la cible auxiliaire (2) s'étend au-delà de la surface de la cible principale (1) par une hauteur qui est inférieure ou égale à la largeur de la cible principale (1).

7. Agencement de cibles selon l'une quelconque des revendications précédentes, comprenant une pluralité de cibles auxiliaires (2, 3).

8. Agencement de cibles selon l'une quelconque des revendications précédentes, comprenant une pluralité de cibles auxiliaires (2, 3) qui sont surélevées à différentes hauteurs au-dessus de la cible principale (1).

9. Agencement de cibles selon l'une quelconque des revendications précédentes, dans lequel la cible principale (1) et la cible auxiliaire (2) sont réalisées dans la même matière.

10. Agencement de cibles selon l'une quelconque des revendications 1 à 8, dans lequel la cible principale (1) et la cible auxiliaire (2) sont réalisées dans des matières différentes.

11. Agencement de cibles selon la revendication 10, dans lequel la cible principale (1) est réalisée en une matière non magnétique.

12. Agencement de cibles selon l'une quelconque des revendications précédentes, dans lequel les cibles (1, 2) sont montées à des niveaux de base différents.

13. Agencement de cibles selon l'une quelconque des revendications précédentes, présentant plus d'une plaque de support et dans lequel les cibles (1, 2) ne sont pas toutes montées sur la même plaque de support.

14. Agencement de cibles selon l'une quelconque des revendications précédentes, dans lequel la cible principale (1) peut être remplacée indépendamment de la cible auxiliaire (2).

15. Agencement de cibles selon l'une quelconque des revendications 4 à 13, dans lequel l'espace (12) entre la cible principale (1) et la cible auxiliaire (2) ne dépasse pas 10 mm de large.

16. Agencement de cibles selon l'une quelconque des revendications précédentes, dans lequel l'espace (12) entre la cible principale (1) et la cible auxiliaire (2) ne dépasse pas 5 mm de large.

17. Agencement de cibles selon l'une quelconque des revendications précédentes, dans lequel la largeur de l'espace (12) entre la cible principale (1) et la cible auxiliaire (2) est comprise entre 1 et 2 mm.

18. Agencement de cibles selon l'une quelconque des revendications précédentes, dans lequel l'espace (12) entre la cible principale (1) et la cible auxiliaire (2) a une profondeur d'au moins 30% de l'épaisseur de la cible principale (1).

19. Agencement de cibles selon l'une quelconque des revendications précédentes, dans lequel l'espace (12) entre la cible principale (1) et la cible auxiliaire (2) a une profondeur d'au moins 70% de l'épaisseur de la cible principale (1).

20. Agencement de cibles selon l'une quelconque des revendications précédentes, dans lequel l'espace (12) entre la cible principale (1) et la cible auxiliaire (2) a une profondeur comprise entre 90% et 100% de l'épaisseur de la cible principale (1).

21. Agencement de cibles selon l'une quelconque des revendications précédentes, dans lequel la cible principale (1) est profilée, ayant une surface fendue.

22. Dispositif destiné à être utilisé dans un processus de pulvérisation sous vide comprenant un agencement de cibles selon l'une quelconque des revendications précédentes.

23. Dispositif destiné à être utilisé dans la pulvérisation magnétron comprenant l'agencement de cibles selon l'une quelconque des revendications précédentes, et comprenant en outre :
un moyen magnétique (4) pour créer un champ magnétique dans une région par-dessus les cibles (1, 2),
le champ magnétique par-dessus la cible principale (1) étant confiné dans une zone de grande force de champ magnétique homogène (6) sensiblement parallèle à la surface de la cible principale (1).

24. Dispositif selon la revendication 23, dans lequel les moyens magnétiques (4) sont situés directement derrière la cible auxiliaire (2), ou à proximité de celle-ci.

25. Utilisation d'un dispositif selon la revendication 23 ou 24 pour pulvériser.
